# EUROPEAN PATENT APPLICATION

(11) **EP 4 589 377 A1**
(43) Date of publication of application: **23.07.2025**
(21) Application number: 23925690.2
(22) Date of filing: 06.03.2023
(51) Int. Cl.: G02F 1/1343, G02F 1/1339, H01L 27/12, G02F 1/1345

(54) **ARRAY SUBSTRATE AND DISPLAY APPARATUS**

(71) Applicant: Boe Technology Group Co., Ltd., Beijing 100015 (CN); Hefei Boe Display Technology Co., Ltd., Hefei, Anhui 230012 (CN)
(72) Inventor: ZHANG, Chunxu, Beijing 100176 (CN); DU, Yue, Beijing 100176 (CN); DAI, Ke, Beijing 100176 (CN); YANG, Haipeng, Beijing 100176 (CN); ZHOU, Maoxiu, Beijing 100176 (CN); CHENG, Min, Beijing 100176 (CN); JIANG, Xiaoting, Beijing 100176 (CN)
(74) Representative: Cohausz & Florack
(86) International application number: PCT/CN2023/079762
(87) International publication number: WO 2024/182965

(57) **Abstract**

The present disclosure provides an array substrate and a display apparatus. The array substrate includes: a base substrate including a display region, the display region includes a plurality of sub-pixel regions arranged in an array, colors of the sub-pixel regions in the same row are the same, at least two adjacent sub-pixel regions in the same column are one pixel region, and colors of the sub-pixel regions in the same one pixel region are different; a plurality of gate lines at row gaps of the sub-pixel regions, where one gate line is coupled with one row of the sub-pixel regions; a plurality of data lines at column gaps of the sub-pixel regions, where one data line is coupled with two columns of the sub-pixel regions, the sub-pixel regions located in adjacent rows coupled with the same one data line are respectively located in adjacent columns, at least some of the data lines includes abutments for supporting spacers, and the data lines are widened at the abutments; and at least one barrier wall that is close to the abutment, where in a direction pointing perpendicularly from the base substrate to a layer where the data lines are located, a surface of the barrier wall facing away from the base substrate is higher than a surface of the data line facing away from the base substrate, and the barrier wall at least partially surrounds the abutment.

## Description

### Technical Field

The present disclosure relates to the field of display technology, and in particular to an array substrate and a display apparatus.

### Background

The thin film transistor liquid crystal display (TFT-LCD) has rapidly developed in recent years due to its small size, low power consumption, high image quality, no radiation, and portability, etc. It has gradually replaced the traditional cathode ray tube (CRT) display and dominates the current flat panel display market. Currently, TFT-LCD is widely used in products of various sizes, covering almost all major electronic products, such as liquid crystal televisions, high-definition digital televisions, computers (desktop and laptop), mobile phones, tablets, navigation systems, in-vehicle displays, projection displays, video cameras, digital cameras, electronic watches, calculators, electronic instruments, meters, public displays, and virtual displays, etc., in today's information society.

### Summary

The present disclosure provides an array substrate and a display apparatus, the specific solutions are as follows.

On the one hand, embodiments of the present disclosure provide an array substrate including: a base substrate, where the base substrate includes a display region, the display region includes a plurality of sub-pixel region arranged in an array, colors of the sub-pixel regions in the same row are the same, at least two sub-pixel regions that are adjacent to each other and in the same column are one pixel region, and colors of the sub-pixel regions in the same one pixel region are different; a plurality of gate lines and a plurality of pixel circuits, located at row gaps of the sub-pixel regions, where one gate line is coupled with one row of the sub-pixel regions through the pixel circuits; a plurality of data lines, located at column gaps of the sub-pixel regions, where one data line is coupled with two columns of the sub-pixel regions through the pixel circuits, the sub-pixel regions coupled with the same one data line and located in rows that are adjacent to each other are respectively located in columns that are adjacent to each other, at least some of the data lines includes abutments for supporting spacers, and the at least some of the data lines are widened at the abutments; and at least one barrier wall close to the abutment, where in a direction pointing perpendicularly from the base substrate to a layer where the data lines are located, a surface of the barrier wall facing away from the base substrate is higher than a surface of the data line facing away from the base substrate, and the barrier wall at least partially surrounds the abutment.

In some embodiments, in the array substrate provided in embodiments of the present disclosure, the abutments are located between at least some of the sub-pixel regions that are adjacent to each other in the same row, the gate lines includes a first gate line, and the first gate line is coupled with the sub-pixel regions in a row in which the abutments are located; the barrier wall includes a first barrier wall, and the first barrier wall is bent from a side of the abutment extending in a column direction to a side of the abutment away from the first gate line.

In some embodiments, in the array substrate provided in embodiments of the present disclosure, the pixel circuits include transistors, the transistors are coupled with the data lines, the gate lines, and the sub-pixel regions, respectively; the transistors include a first transistor, the first transistor is coupled with the data line in which the abutment is located, and the first transistor is adjacent to the abutment on a side of the abutment extending in the column direction; and the first barrier wall includes a first barrier sub-wall and a second barrier sub-wall; the first barrier sub-wall and the first transistor are located on the same side of the abutment; and the first barrier sub-wall is located on a side of the first transistor away from the first gate line; the second barrier sub-wall and the first transistor are separated on both sides of the abutment, an end portion of the second barrier sub-wall away from the first gate line is substantially flush with an end portion of the first barrier sub-wall away from the first gate line in a row direction; and an end portion of the second barrier sub-wall close to the first gate line is closer to the first gate line than an end portion of the first barrier sub-wall close to the first gate line.

In some embodiments, in the array substrate provided in embodiments of the present disclosure, the barrier wall further includes a second barrier wall, and the second barrier wall extends in the column direction on a side of the first barrier wall away from the abutment; on the same side of the abutment extending in the column direction, and an end portion of the second barrier wall close to the first gate line is substantially flush with an end portion of the first barrier wall close to the first gate line in the row direction; and an end portion of the second barrier wall away from the first gate line is closer to the first gate line than an end portion of the first barrier wall away from the first gate line.

In some embodiments, in the array substrate provided in embodiments of the present disclosure, the pixel circuits include transistors, the transistors are coupled with the data lines, the gate lines, and the sub-pixel regions, respectively; the transistors include a first transistor, the first transistor is coupled with the data line in which the abutment is located, and the first transistor is adjacent to the abutment on a side of the abutment extending in the column direction; and the second barrier wall includes a third barrier sub-wall and a fourth barrier sub-wall; the third barrier sub-wall and the first transistor are located on the same side of the abutment, and the third barrier sub-wall is located on a side of the first transistor away from the first gate line; the fourth barrier sub-wall and the first transistor are separated on both sides of the abutment, an end portion of the fourth barrier sub-wall away from the first gate line is substantially flush with an end portion of the third barrier sub-wall away from the first gate line in a row direction, and an end portion of the fourth barrier sub-wall close to the first gate line is closer to the first gate line than an end portion of the third barrier sub-wall close to the first gate line.

In some embodiments, the array substrate provided in embodiments of the present disclosure further includes a plurality of common electrodes and a plurality of adapter lines; where the common electrodes are located in the sub-pixel regions, the common electrodes located in the same row are integrally arranged; the common electrodes that are adjacent to each other in the same column are connected through the adapter line; the adapter lines are arranged in the same layer as the data lines, and some of the adapter lines are close to the abutment on a side of the abutment away from the first transistor.

In some embodiments, in the array substrate provided in embodiments of the present disclosure, the abutment includes a spacer station region, a center of the spacer station region is closer to the first gate line than a center of the abutment.

In some embodiments, in the array substrate provided in embodiments of the present disclosure, the barrier wall includes a first barrier wall portion and a second barrier wall portion that are stacked; the first barrier wall portion is in the same layer as the gate lines, and the second barrier wall portion is in the same layer as the data lines.

In some embodiments, in the array substrate provided in embodiments of the present disclosure, the array substrate further includes: a plurality of pixel electrodes located in the sub-pixel regions; where the pixel electrode includes a plurality of slits, and orthographic projections of the plurality of slits on the base substrate and an orthographic projection of the barrier wall on the base substrate overlap with each other.

In some embodiments, in the array substrate provided in embodiments of the present disclosure, the orthographic projections of the plurality of slits on the base substrate and orthographic projections of the gate lines on the base substrate do not overlap with each other.

In some embodiments, in the array substrate provided in embodiments of the present disclosure, the array substrate further includes: a plurality of common electrodes and a plurality of common electrode lines; the common electrodes are located in the sub-pixel regions, one common electrode line is coupled with one row of common electrodes; and the orthographic projections of the plurality of slits on the base substrate and orthographic projections of the common electrode lines on the base substrate overlap with each other.

In some embodiments, in the array substrate provided in embodiments of the present disclosure, a length of the pixel electrode in the row direction is greater than a length of the pixel electrode in the column direction.

In some embodiments, the array substrate provided in embodiments of the present disclosure further includes: a plurality of common electrodes and a plurality of common electrode lines; where the pixel circuits include transistors, the transistors are coupled with the data lines, the gate lines, and the sub-pixel regions, respectively; the common electrodes are located in the sub-pixel regions; one common electrode line is coupled with one row of common electrodes; and the common electrode line includes avoidance portions, the avoidance portions are recessed towards a side away from the transistors.

In some embodiments, in the array substrate provided in embodiments of the present disclosure, the pixel circuits include transistors, the transistors are coupled with the data lines, the gate lines, and the sub-pixel regions, respectively; the transistor includes a gate electrode, a first electrode of the transistor is a W-shaped structure, and a second electrode of the transistor is a U-shaped structure; an orthographic projection of the W-shaped structure on the base substrate is within an orthographic projection of the gate electrode on the base substrate; and parallel edges of the U-shaped structure are respectively within two openings of the W-shaped structure.

In some embodiments, in the array substrate provided in embodiments of the present disclosure, the base substrate further includes at least one fan-out region located on a side of the display region; and the array substrate further includes: a plurality of fan-out lines and a plurality of first dummy lines in the fan-out region, the fan-out lines are coupled with the data lines; the first dummy lines are between at least some of the fan-out lines; and the first dummy lines are routed within gaps between the fan-out lines, and along the boundaries of the gaps.

In some embodiments, in the array substrate provided in embodiments of the present disclosure, the gap is a closed space surrounded by the fan-out lines, the closed space have a plurality of closed first dummy lines routed along a boundary of the closed space.

In some embodiments, in the array substrate provided in embodiments of the present disclosure, the closed space includes a first convex portion extending towards a center of the closed space, and at least the first dummy line close to the boundary of the closed space includes a second convex portion around the first convex portion.

In some embodiments, in the array substrate provided in embodiments of the present disclosure, all of the first dummy lines within the closed space include the second convex portions.

In some embodiments, in the array substrate provided in embodiments of the present disclosure, the first dummy line close to the boundary of the closed space includes the second convex portion, and the first dummy line located in a center region of the closed space is a rectangular dummy line.

In some embodiments, in the array substrate provided in embodiments of the present disclosure, the closed space is rectangular and the first dummy line is a rectangular dummy line.

In some embodiments, in the array substrate provided in embodiments of the present disclosure, the gap is a semi-closed space that opens on a side towards the display region; the semi-closed space is located on a side of the closed space away from a symmetry axis extending in the column direction of the fan-out region; and the semi-closed space at least have a plurality of semi-closed first dummy lines routed along a boundary of the semi-closed space.

In some embodiments, in the array substrate provided in embodiments of the present disclosure, all of the first dummy lines within the semi-closed space are semi-enclosed dummy lines routed along the boundary of the semi-closed space.

In some embodiments, in the array substrate provided in embodiments of the present disclosure, the first dummy line close to the boundary of the semi-closed space is the semi-enclosed dummy line, and the first dummy line located in a center region of the semi-closed space is a closed dummy line.

In some embodiments, in the array substrate provided in embodiments of the present disclosure, at least some of the fan-out lines includes: serpentine lines, straight lines, and oblique lines sequentially connected in a direction away from the display region; at least some of the straight lines, the serpentine lines, and the oblique lines enclose a closed space; and the closed space includes at least one of: a rectangular first dummy line, a serpentine first dummy line, a first dummy line parallel to the straight line, or a first dummy line substantially perpendicular to the straight line.

In some embodiments, the array substrate provided in embodiments of the present disclosure includes at least two fan-out regions, and a first common electrode bus between two fan-out regions that are adjacent to each other; and a plurality of second dummy lines between the fan-out regions and the first common electrode bus; where the first common electrode bus includes a plurality of common electrode sub-lines connected in parallel, the common electrode sub-lines are substantially parallel to the fan-out lines at edges, that are adjacent to the common electrode sub-lines, of the two fan-out regions; the plurality of second dummy lines are connected in parallel or are arranged independently of each other, and the second dummy lines are substantially parallel to the fan-out line at an edge of a single fan-out region that is adjacent to the second dummy lines.

In some embodiments, the array substrate provided in embodiments of the present disclosure further includes a first parallel line and a second parallel line between the two fan-out regions that are adjacent to each other, and a second common electrode bus in the non-display region and extending in an extending direction of the gate line; where the first parallel line is coupled between middle portions of the plurality of common electrode sub-lines and the second common electrode bus, and the second parallel line is coupled with end portions of the plurality of common electrode sub-lines.

In some embodiments, in the array substrate provided in embodiments of the present disclosure, a distance between the first common electrode bus and the second dummy line is greater than a distance between the second dummy line and the fan-out line.

In some embodiments, in the array substrate provided in embodiments of the present disclosure, a line width of the first dummy line, a line width of the second dummy line, and a line width of the common electrode sub-line are substantially the same as a line width of the fan-out line, and a line space between the first dummy lines, a line space between the second dummy lines, and a line space between the common electrode sub-lines are 1 to 10 times a line space between the fan-out lines.

On the other hand, embodiments of the present disclosure provide a display apparatus including: an array substrate and an opposing substrate opposite to each other, and a liquid crystal layer between the array substrate and the opposing substrate, where the array substrate is the aforementioned array substrate provided in embodiments of the present disclosure.

In some embodiments, in the display apparatus provided by embodiments of the present disclosure, the opposing substrate includes a black matrix; and an orthographic projection of the barrier wall on the base substrate is within an orthographic projection of the black matrix on the base substrate.

In some embodiments, in the display apparatus provided by embodiments of the present disclosure, the array substrate includes a common electrode line; in the sub-pixel region, the orthographic projection of the black matrix on the base substrate exceeds 3 µm to 7 µm than an orthographic projection of the common electrode line on the substrate.

In some embodiments, the display apparatus provided by embodiments of the present disclosure, the array substrate includes pixel electrodes, and each the pixel electrode includes slits; at least some of the slits include: a first end close to the common electrode line, and a second end away from the common electrode line; where an orthographic projection of the first end on the base substrate and the orthographic projection of the black matrix on the base substrate overlap with each other, and an orthographic projection of the second end on the base substrate and the orthographic projection of the black matrix on the base substrate do not overlap with each other.

In some embodiments, in the display apparatus provided by embodiments of the present disclosure, the data line includes the abutment, and the abutment includes a spacer station region; the opposing substrate includes a spacer; a size of the spacer gradually decreases in a direction pointing from the opposing substrate to the liquid crystal layer; and an orthographic projection of an end portion of the spacer close to the array substrate on the base substrate substantially coincides with an orthographic projection of the spacer station region on the base substrate.

### Brief Description of Figures

FIG. 1 is a schematic structural diagram of an array substrate provided by embodiments of the present disclosure.
FIG. 2 is an enlarged schematic diagram of a region z₁ in FIG. 1.
FIG. 3 is a schematic structural diagram of a region z₂ in FIG. 2.
FIG. 4 is a cross-sectional view along a line I-II in FIG. 3.
FIG. 5 shows a schematic structural diagram of a layer where a common electrode is located in FIG. 2.
FIG. 6 shows a schematic structural diagram of a layer where gate lines are located in FIG. 2.
FIG. 7 shows a schematic structural diagram of an active layer in FIG. 2.
FIG. 8 shows a schematic structural diagram of a layer where data lines are located in FIG. 2.
FIG. 9 shows a schematic structural diagram of an insulation layer in FIG. 2.
FIG. 10 shows a schematic structural diagram of a pixel electrode(s) in FIG. 2.
FIG. 11 is an enlarged schematic diagram of a region z in FIG. 1.
FIG. 12 is an enlarged schematic diagram of a region z₃ in FIG. 1.
FIG. 13 is an enlarged schematic diagram of a region z₄ in FIG. 1.
FIG. 14 is an enlarged schematic diagram of a region z₅ in FIG. 1.
FIG. 15 is an enlarged schematic diagram of a region z₆ in FIG. 1.
FIG. 16 is another enlarged schematic diagram of a region z₆ in FIG. 1.
FIG. 17 is another enlarged schematic diagram of a region z₆ in FIG. 1.
FIG. 18 is another enlarged schematic diagram of a region z₆ in FIG. 1.
FIG. 19 is an enlarged schematic diagram of a region z' in FIG. 1.
FIG. 20 is an enlarged schematic diagram of a region z₇ in FIG. 1.
FIG. 21 is a schematic structural diagram of a display apparatus provided by embodiments of the present disclosure.
FIG. 22 is a cross-sectional view along a line III-IV in FIG. 21.

### Detailed Description

In order to make the purpose, technical solutions and advantages of embodiments of the present disclosure more clear, the technical solutions of embodiments of the present disclosure will be clearly and completely described below in conjunction with the drawings of embodiments of the present disclosure. It should be noted that, in order to make the purpose, technical solutions and advantages of embodiments of the present disclosure more clear, the technical solutions of embodiments of the present disclosure will be clearly and completely described below in conjunction with the drawings of embodiments of the present disclosure. It should be noted that in the accompanying drawings, the thickness of a layer, a film, a panel, a region, etc., is enlarged for clarity. In the present disclosure, an exemplary embodiment is described by referring to a cross-sectional diagram as a schematic diagram of an idealized embodiment. In this way, deviations from the shape of the drawing as a result of, for example, manufacturing techniques and/or tolerances are expected. Thus, embodiments described in the present disclosure should not be construed as being limited to the specific shape of a region as shown in the present disclosure, but rather include deviations in shape caused by, for example, manufacturing. For example, regions illustrated or described as flat may typically have rough and/or non-linear features; sharp corners illustrated may be rounded, etc. Thus, the regions shown in the drawings are schematic in nature, and their dimensions and shapes do not purport to be the exact shape of the regions shown, do not reflect true proportions, and are intended to be illustrative of the present disclosure only. And the same or similar labels throughout represent the same or similar components or components with the same or similar functions. In order to keep the following description of embodiments of the present disclosure clear and concise, the present disclosure omits detailed descriptions of known functions and known components.

Unless otherwise defined, technical or scientific terms used herein shall have their ordinary meaning understood by a person of ordinary skill in the art to which the present disclosure belongs. "First", "second" and similar words used in the description and the claims of the present disclosure do not indicate any order, quantity or importance, but are only used to distinguish different components. Words such as "include" or "comprise" mean that the elements or objects appearing before the word include the elements or objects listed after the word and their equivalents, without excluding other elements or objects. The words "connection", "connecting", etc. are not limited to physical or mechanical connection, but can include electrical connection whether direct or indirect. Words such as "inside", "outside", "up", "down" are only used to express relative positional relationships. When the absolute position of the described object is changed, the relative positional relationship may also be changed accordingly.

In the following description, when an element or a layer is described as being "on another element or layer" or "connected with another element or layer", the element or layer may be directly on another element or layer or directly connected with another element or layer, or there may be an intermediate element or an intermediate layer. When an element or a layer is described as being "arranged on another element or layer", the element or layer may be directly on another element or layer or directly connected with another element or layer, or there may be an intermediate element or an intermediate layer. However, when an element or a layer is described as being "directly on another element or layer" or "directly connected with another element or layer", there is no intermediate element or intermediate layer. Word "and/or" indicates any and all combinations of one or more associated listed items.

At present, the competition in the display field is increasingly fierce, and low-cost thinking is implemented throughout the display field. Compared with the conventional scheme that three sub-pixels in the same one pixel are controlled by three data lines and one gate line, in the tri-gate scheme, six sub-pixels in two pixels are controlled by two data lines and three gate lines, so that the data lines are reduced to one third of that in the conventional scheme. Correspondingly, the number of source drive circuits is reduced, and the material cost is greatly reduced, which is especially suitable for large size LCD products, such as vehicle mounted displays, TVs.

In order to control the uniformity of the LCD cell gap and make the LCD product have good compression resistance when stressed, a spacer (PS) is usually arranged between the two substrates of the LCD product. However, when the LCD product is transported and pressure tested, the spacer may shift due to stress, which may scratch the alignment layer (PI), thus causing the LCD at the scratched portion to become disordered and leak light, affecting the display effect. For tri-gate products, since the direction of the gate line(s) changes to the direction of the long side of the sub-pixel(s) after the sub-pixel is inverted, the direction of the data line(s) changes to the direction of the short side of the sub-pixel(s), and the opening direction of the slit electrode also changes accordingly, which leads to the light leakage region changing from the direction of the gate line to the direction of the data line. In order to solve the problem of light leakage, a wider black matrix (BM) is needed to block the spacer, resulting in a decrease in the aperture ratio.

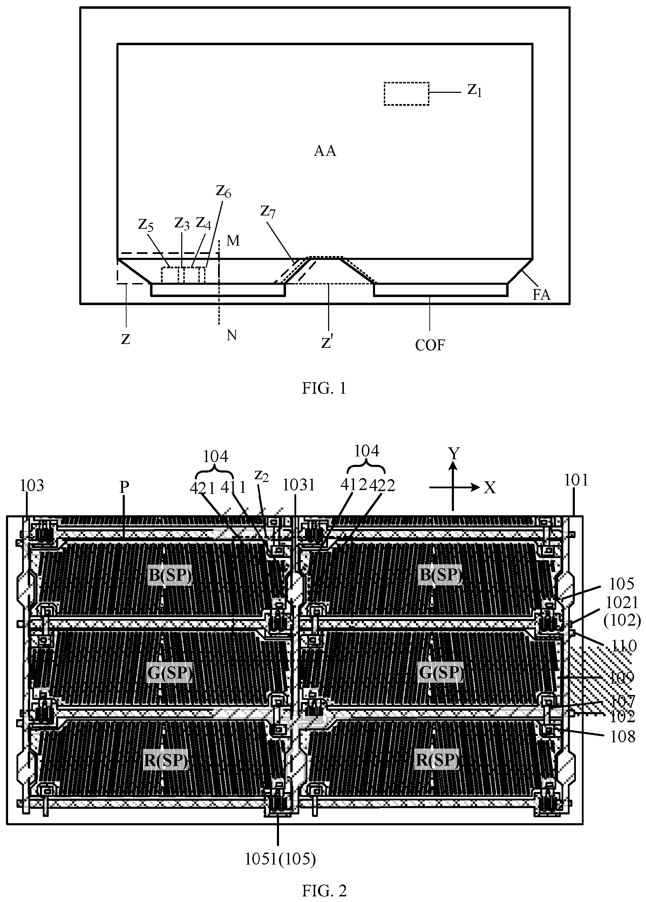

In order to improve the above technical problems existing in the related art, embodiments of the present disclosure provide an array substrate, as shown in FIGS. 1 to 4, including a base substrate 101, a plurality of gate lines 102 and a plurality of pixel circuits (including transistors 105), a plurality of data lines 103 and at least one barrier wall 104.

The base substrate 101 includes a display region AA, the display region AA includes a plurality of sub-pixel regions SP arranged in an array, the colors of the sub-pixel regions SP in the same row are the same, at least two sub-pixel regions SP that are adjacent to each other and in the same column are one pixel region P, and the colors of the sub-pixel regions SP in the same pixel region P are different. Here, a row direction of the "row" refers to an extending direction of gate line(s) 102, and a column direction of the "column" refers to an extending direction of data line(s) 103. Exemplarily, the sub-pixel region P includes a red sub-pixel region R, a green sub-pixel region G, and a blue sub-pixel region B. In the same column, the red sub-pixel region R, the green sub-pixel region G, and the blue sub-pixel region B that are adjacent to each other form one pixel region P. It should be noted that, in the present disclosure, it is illustrated that one pixel includes three sub-pixels. Optionally, it can also include four or other number of sub-pixels, for example, it also includes a white sub-pixel, which is not limited here. In addition, the color of the sub-pixel region SP can be understood as: after the opposing substrate and the array substrate are boxed aligning, the color of the sub-pixels corresponding to the color resistances set on the opposing substrate, or the color of the sub-pixels corresponding to the color resistance structure set on the array substrate (that is, color filter on array (COA) technology).

The plurality of gate lines 102 and the plurality of pixel circuits (including transistors 105) are located at row gaps of the sub-pixel regions PS, and one gate line 102 is coupled with one row of sub-pixel regions SP through the pixel circuits (that is, coupled with the pixel electrodes 109 of the sub-pixel regions SP). In some embodiments, one transistor 105 is coupled with one pixel electrode 109. Optionally, the material of the gate lines 102 can include metals such as molybdenum (Mo), aluminum (Al), copper (Cu), titanium (Ti), chromium (Cr), or nickel (Ni), etc. The gate lines 102 can be a single-layer structure or a laminated structure, for example, the gate line 102 is a single-layer structure composed of a molybdenum metal layer. The "coupling" in the present disclosure can be either a direct electrical connection or an indirect electrical connection, such as electrical connection through other lines or components (transistors, etc.).

The plurality of data lines 103 at column gaps of the sub-pixel regions SP; one data line 103 is coupled with two column sub-pixel regions SP through the pixel circuits; the sub-pixel regions SP coupled with the same data line 103 and located in adjacent rows are respectively located in adjacent columns, at least some of the data lines 103 includes abutments 1031 for supporting spacers PS. In order to improve the support stability, the data line(s) 10 can be widened at the abutment(s) 1031. Optionally, the shape of the spacer(s) PS can be octagonal. On the basis of the shape of the spacer PS, the abutment 1031 can be expanded by one circle, such as expanded by 3 µm to7 µm. In some embodiments, the material of the data lines 103 can include metals such as molybdenum (Mo), aluminum (Al), copper (Cu), titanium (Ti), chromium (Cr), nickel (Ni), etc. The data lines 103 can be a single-layer structure or a laminated structure, for example, the data line 103 is a laminated structure composed of titanium metal layer/aluminum metal layer/titanium metal layer.

At least one barrier wall 104 is arranged close to the abutment 1031, and the barrier wall 104 at least partially encloses the abutment 1031. In a direction Z pointing perpendicularly from the base substrate 101 to a layer where the data lines 103 are located, a surface of the barrier wall 104 facing away from the base substrate 101 is higher than a surface of the data line 103 facing away from the base substrate 101. In other words, the barrier wall 104 will be higher than the data line 103. Optionally, the barrier wall 104 includes a first barrier wall portion 104' and a second barrier wall portion 104" that are stacked. The first barrier wall portion 104' is arranged in the same layer as the gate line 102 and made of the same material as the gate line 102, and the second barrier wall portion 104" is arranged in the same layer as the data line 103 and made of the same material as the data line 103. So that, the second barrier wall portion 104" in the same layer as the data line 103 can be higher than the data line 103 due to the heightening effect of the first barrier wall portion 104' in the layer where the gate lines 102 are located.

In the above array substrate provided by embodiments of the present disclosure, by setting the barrier wall 104 which is higher than the abutment 1031 is provided near the abutment 1031, the spacer PS can be effectively prevented from sliding out of the barrier wall 104, thus avoiding the light leakage caused by the spacer PS scratching the alignment layer. Moreover, by setting the barrier wall 104 that at least partially surrounds the abutment 1031, that is, the shape of the barrier wall 104 bends along the possible sliding direction of the spacer PS. In this way, the barrier wall 104 and the abutment 1031 can share the black matrix that blocks the abutment 1031 without further occupying the opening region. If the barrier wall 104 is designed as a regular straight strip extending along the direction (i.e., the column direction Y) of the data line 103, a corresponding black matrix shall be added to prevent the metal reflection caused by the leaking out of the barrier wall 104. Therefore, in the present disclosure, it is conducive to improving the aperture ratio by setting the barrier wall 104 at least partially surrounding the abutment 1031.

In the present disclosure, "in the same layer" refers to forming a film layer for making specific patterns by using the same film forming process, and then forming a layer structure through one-time patterning process using the same one mask template. That is, one-time patterning process corresponds to one mask template (mask, also known as photomask). According to different specific patterns, the single patterning process may include multiple times of exposure, developing or etching processes, while the specific patterns in the formed layer structure may be continuous or discontinuous, and these specific patterns may be at the same height or have the same thickness, and may also be at different heights and have different thicknesses.. Based on this, by setting the first barrier wall portion 104' to be in the same layer as the gate line 102 and the second barrier wall portion 104" to be in the same layer as the data line 103, the number of times of masking can be reduced, the production efficiency can be improved, and the number of film layers can be reduced, which is conducive to the thin and light design of products.

In some embodiments, in the above array substrate provided by the embodiment of the present disclosure, as shown in FIGS. 2, 3, 6 and 8, the abutments 1031 are located between at least some of sub-pixel regions SP that are adjacent to each other in the same one row, the gate lines 102 includes a first gate line 1021, and the first gate line 1021 is coupled with the sub-pixel regions SP in a row in which the abutments 1031 are located; the barrier wall 104 includes a first barrier wall 1041, which is bent from the side of the abutment 1031 extending in the column direction Y to the side of the abutment 1031 away from the first gate line 1021 to prevent the spacer PS from sliding diagonally upward to the left or diagonally upward to the right, without further occupying the opening region.

In some embodiments, in the above array substrate provided by the embodiment of the present disclosure, as shown in FIGS. 2, 3, 6 to 8, the transistors 105 are respectively coupled with the data line(s) 103, the gate line(s) 102, and the sub-pixel region(s) SP (that is, coupled with pixel electrode(s) 109 of sub-pixel region(s) SP). The transistors 105 include a first transistor 1051, the first transistor 1051 is coupled with the data line 103 where the abutment 1031 is located; the first transistor 1051 is adjacent to the abutment 1031 on the side of the abutment 1031 extending in the column direction Y. For example, the first transistor 1051 is located at the lower left corner with respect to the abutment 1031. The first barrier wall 1041 includes the first barrier sub-wall 411 and the second barrier sub-wall 412; the first sub-barrier 411 and the first transistor 1051 are arranged on the same side of the abutment 1031, and the first sub-barrier 411 is located on the side of the first transistor 1051 away from the first gate line 1021. The second sub-barrier 412 and the first transistor 1051 are respectively located on both sides of the abutment 1031. In this way, the first sub-barrier 411 can be used to prevent the spacer PS from sliding towards the left or upper left sides of the abutment 1031, and the second barrier sub-wall 412 is used to prevent the spacer PS from sliding towards the right side or upper right of the abutment 1031, while the first transistor 1051 can prevent the spacer PS from sliding towards the lower left of the abutment 1031.

In addition, in order to effectively prevent the spacer PS from sliding to the upper left or upper right of the abutment 1031, the end portion of the second barrier sub-wall 412 away from the first gate line 1021 can be set substantially flush with the end portion of the first barrier sub-wall 411 away from the first gate line 1021 in the row direction X (that is, flush or within the error range caused by manufacturing, measurement and other factors). At the same time, due to the existence of the first transistor 1051, the wiring space on the left side, provided with the first transistor 1051, of the abutment 1031 is smaller than the wiring space on the right side of the abutment 1031. Therefore, the end portion of the second sub-barrier 412 on the right side of the abutment 1031 close to the first gate line 1021 can be closer the first gate line 1021 than the end portion of the first sub-barrier 411 on the left side of the abutment 1031 close to the first gate line 1021. In this way, the second barrier sub-wall 412 can also be used to prevent the spacer PS from sliding towards the lower right of the abutment 1031 to a certain extent.

Considering that if the first barrier wall 1041 is closer to the spacer PS, for example, if the distance between the first barrier wall 1041 and the edge of the end portion of the spacer PS close to the array substrate is less than 20 µm, the second barrier wall 1042 can be added outside the first barrier wall 1041. In this way, the second barrier wall 1042 can be used for further blocking after the spacer PS is pressed and may burst out of the first barrier wall 1041. However, if the first barrier wall 1041 is farer away from the spacer PS, for example, if the distance between the first barrier wall 1041 and the edge of the end portion of the spacer PS close to the array substrate is greater than 20 µm, the second barrier wall 1042 may not be designed. For example, the bent part of the first barrier wall 1041 is relatively far away from the spacer PS, so the second barrier wall 1042 is not set outside the bent part of the first barrier wall 1041; and the straight part of the first barrier wall 1041 is relatively close to the spacer PS, so the second barrier wall 1042 is set outside the straight part of the first barrier wall 1041.

Based on this, in the array substrate provided by the embodiment of the present disclosure, as shown in FIGS. 2 to 4, and FIGS. 6 to 8, the barrier wall 104 can also include a second barrier wall 1042, the second barrier wall 1042 extends in the column direction Y on the side of the first barrier wall 1041 away from the abutment 1031. On the same side of abutment 1031 extending along the column direction Y, the end portion of the second barrier wall 1042 close to the first gate line 1021 is substantially flush with the end portion of the first barrier wall 1041 close to the first gate line 1021 in the row direction X (that is, flush or within the error range caused by manufacturing, measurement and other factors). The end portion of the second barrier wall 1042 away from the first gate line 1021 is closer to the first gate line 1021 than the end portion of the first barrier wall 1041 away from the first gate line 1021. In some embodiments, the end portion of the second barrier wall 1042 away from the first gate line 1021 is closer to the first gate line 1021 than the end portion of a straight part, extending along the column direction Y, of the first barrier wall 1041 away from the first gate line 1021.

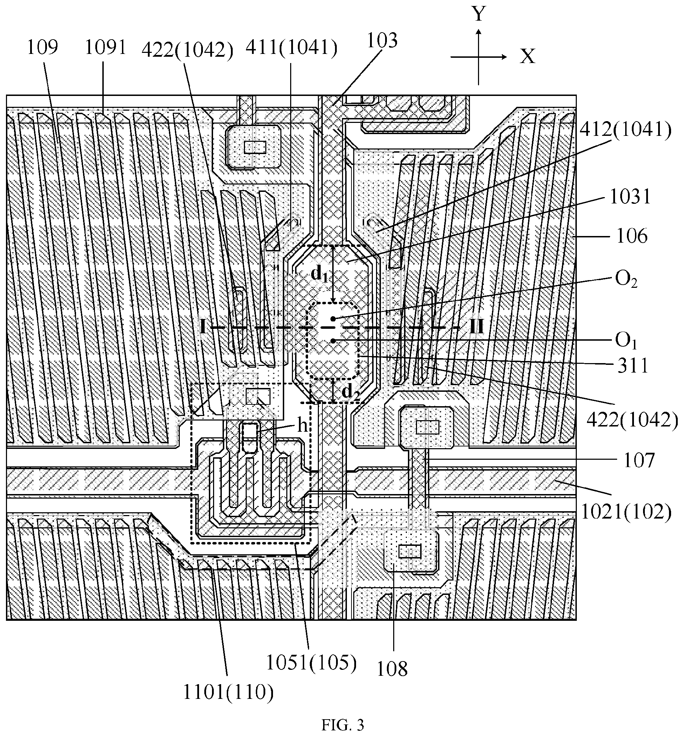

In some embodiments, in order to further prevent the spacer PS from sliding out on the left and right sides of the abutment 1031, as shown in FIGS. 3, 6 and 8, the second barrier wall 1042 can include the third barrier sub-wall 421 and the fourth barrier sub-wall 422. The third sub-barrier 421 and the first transistor 1051 are located on the same side of the abutment 1031, and the third sub-barrier 421 is located on the side of the first transistor 1051 away from the first gate line 1021. The fourth sub-barrier 422 and the first transistor 1051 are respectively located on both sides of the abutment 1031. The end portion of the fourth sub-barrier 422 away from the first gate line 1021 is substantially flush with the end portion of the third sub-barrier 421 away from the first gate line 1021 in the row direction X (that is, flush or within the error range caused by manufacturing, measurement and other factors). The end portion of the fourth barrier sub-wall 422 close to the first gate line 1021 is closer to the first gate line 1021 than the end portion of the third barrier sub-wall 421 close to the first gate line 1021. Optionally, the end portion of the third barrier sub-wall 421 close to the first gate line 1021 is substantially flush with the end portion of the first barrier sub-wall 411 close to the first gate line 1021 (that is, flush or within the error range caused by manufacturing, measurement and other factors). The end portion of the fourth barrier sub-wall 422 close to the first gate line 1021 is substantially flush with the end portion of the second barrier sub-wall 412 close to the first gate line 1021 (that is, flush or within the error range caused by manufacturing, measurement and other factors).

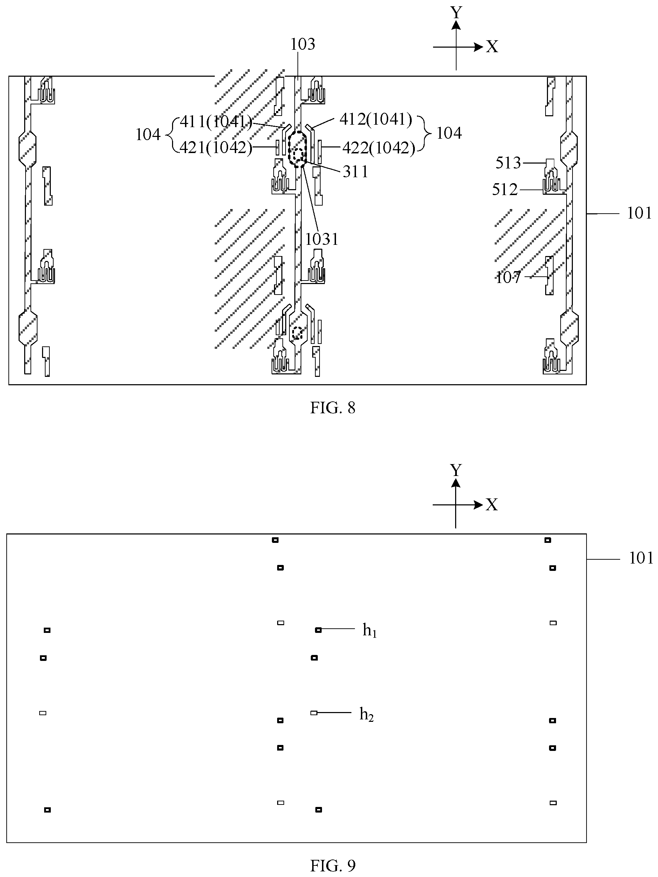

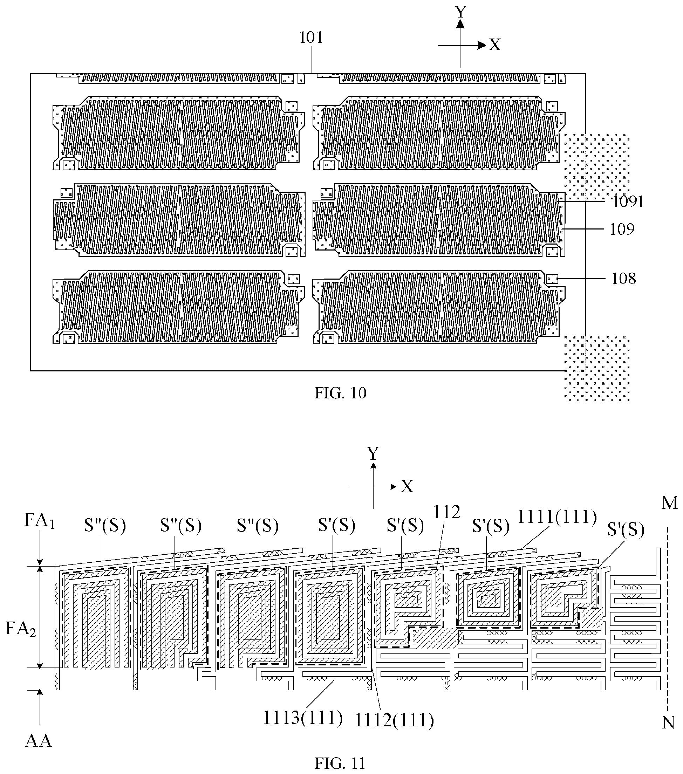

In some embodiments, the array substrate provided in the embodiment of the present disclosure, as shown in FIGS. 2, 3, 5 and 8, can also include a plurality of common electrodes 106 and a plurality of adapter lines 107. The common electrodes 106 are located in the sub-pixel regions SP, and the common electrodes 106 located in the same row are integrally arranged. The common electrodes 106 that are adjacent to each other in the same column are connected through the adapter line(s) 107, so that the adapter line 107 crosses the gate line 102. The adapter lines 107 are in the same layer as the data lines 103. Some of the adapter lines 107 can be located close to the abutment 1031 on a side of the abutment 1031 away from the first transistor 1051 to prevent the spacer PS from sliding out by using the adapter line 107on the lower right side of the abutment 1031. Optionally, as shown in FIGS. 8 to 10, the adapter line 107 can connect the common electrode 106 with the adapter electrode 108 through the first via hole h₁ penetrating through the insulation layer. That is, the adapter line 107 realizes the electrical connection between the adjacent rows of common electrodes 106. At position of the via hole h₁, the adapter line 107 arranged in the same layer as the source and drain metal can be electrically connected with the common electrode 106 through the adapter electrode 108 arranged in the same layer as the pixel electrode 109. Specifically, the adapter electrode 108 and the pixel electrode 109 are arranged in the same layer. Referring to FIG. 10, the pixel electrode 109 adjacent to the adapter electrode 108 is provided with a concave portion at least partially surrounding the adapter electrode 108, so as to avoid electrical connection between the pixel electrode and the adapter electrode 108 when the pixel electrode 109 is relatively large. The first via hole h₁ penetrates the passivation layer (PVX) at the position of the adapter line 107, and the first via hole h₁ penetrates the passivation layer (PVX) and the gate insulation layer (GI) at the position of the common electrode 106. In some embodiments, the materials of the common electrode 106 and the pixel electrode 109 include transparent conductive materials such as indium tin oxide (ITO) and indium zinc oxide (IZO), etc. The materials of gate insulation layer (GI) and passivation layer (PVX) can be at least one of inorganic insulating materials such as silicon oxide, silicon nitride, silicon oxynitride, etc. In addition, by setting the adapter line 107 in the same layer as the data line 103, and the adapter electrode 108 in the same layer as the pixel electrode 109, the number of times of masking can be reduced, the production efficiency can be improved, and the number of film layers can be reduced, which is conducive to the thin and light design of products.

In some embodiments, in the above array substrate provided by the embodiment of the present disclosure, as shown in FIG. 3, the abutment 1031 includes a spacer station region 311, and the orthographic projection of the spacer station region 311 on the base substrate 101 substantially coincides with the orthographic projection of the end portion of the spacer PS towards the array substrate on the base substrate 101 (that is, coincidence or within the error range caused by factors such as manufacturing and measurement). Optionally, the center O₁ of the spacer station region 311 is closer to the first gate line 1021 than the center O₂ of the abutment 1031, which is equivalent to the distance d₁ between the boundary of the spacer station region 311 away from the first gate line 1021 and the boundary of the abutment 1031 away from the first gate line 1021 is greater than the distance d₂ between the boundary of the spacer station region 311 close to the first gate line 1021 and the boundary of the abutment 1031 close to the first gate line 1021, so as to overlap the black matrix needed to block the abutment 1031 with the black matrix needed to block the transistor 105 coupled with the first gate line 1021 as much as possible, thus improving the aperture ratio. At the same time, while ensuring that the aperture ratio is not affected, the distance d₁ can be properly increased, and the resistance of the data line 103 also can be reduced. Optionally, 10 µm≤d₁≤80 µm. For example, d₁ can be 10 µm, 20 µm, 30 µm, 40 µm, 50 µm, 60 µm, 70 µm, or 80 µm, etc.

In some embodiments, in the above array substrate provided by the embodiment of the present disclosure, as shown in FIGS. 2, 3, 8 to 10, the pixel electrode 109 is located in the sub-pixel region SP, the length of the pixel electrode 109 in the row direction X is greater than the length of the pixel electrode 109 in the column direction Y, and the pixel electrode 109 can be coupled with the second electrode 513 of the transistor 105 through the second via h₂ that penetrates the insulation layer (such as the passivation layer PVX). The pixel electrode 109 may include a plurality of slits 1091, and the orthographic projection of some of the slits 1091 on the base substrate 101 overlaps with the orthographic projection of the barrier wall 104 on the base substrate 101. Since the human eyes are more sensitive to green, the panel transmittance is strongly related to the aperture ratio of the green sub-pixel region G. Therefore, in the present disclosure, the spacer PS can be placed on the data line 102 at the column gap between the red sub-pixel regions R, or at the column gap between the blue sub-pixel regions B, to minimize the impact on the aperture ratio of the green sub-pixel region G. At the same time, in order to ensure the consistency of the storage capacitances Cst formed by the common electrodes 106 and the pixel electrodes 109 in the red sub-pixel region R, the blue sub-pixel region B and the green sub-pixel region G, the slits 1091 of the pixel electrodes 109 in the red sub-pixel region R, the blue sub-pixel region B and the green sub-pixel region G can be opened in the same way. Moreover, since it is necessary to arrange a black matrix between the opening regions of the red sub-pixel regions R or between the opening regions of the blue sub-pixel regions B to shield the abutment 1031 for bearing the spacer PS, some of the slits 1091 in the red sub-pixel region R or the blue sub-pixel region B will overlap with the barrier wall 104 close to the abutment 1031 in the direction Z perpendicular to the base substrate 101.

Continuing to refer to FIGS. 2, 3, 6, and 10, it can be seen that the orthographic projection of the slit(s) 1091 on the base substrate 101 may not overlap with the orthographic projection of the gate line(s) 102 on the base substrate 101. This setting ensures that the film layer under the pixel electrode 109 is relatively flat at the position close to gate line 102, so that the orientation of the alignment layer above the pixel electrode 109 at that location is better, and the problem of light leakage does not occur. Therefore, there is no need to use a black matrix for blocking, which is conducive to improving the aperture ratio.

In addition, it can be seen from FIG. 2, FIG. 3, FIG. 6 and FIG. 10 that, in the present disclosure, the array substrate can also have a plurality of common electrode lines 110, which are arranged in the same layer as the gate line 102 and made of the same material as the gate line 102, one common electrode line 110 is coupled with one row of common electrodes 106. Optionally, the common electrode 106 is electrically connected with the common electrode line 110 and is in contact with the common electrode line 110 in stacked. The orthographic projection of the slit(s) 1091 on the base substrate 101 overlaps with the orthographic projection of the common electrode line 110 on the base substrate 101. In this case, since there is the common electrode line 110 blocking the backlight, the slit(s) 1091 at the position of the common electrode line 110 will not have optical defects (such as the phenomenon of display blackening caused by liquid crystal disorder). However, the existence of the common electrode line 110 will cause the position to be higher relative to the opening region, resulting in poor orientation of the alignment layer at this position, and causing the disorder of the liquid crystal at this position. Therefore, the black matrix needs to be used for blocking. In order to ensure a better blocking effect, the size of the black matrix beyond the common electrode line 110 is within the alignment accuracy range (for example, 3 µm to7 µm). General design of the related art exceeds 10 µm. Therefore, compared with the related art, the light exiting area is increased and the transmittance is improved in the present disclosure.

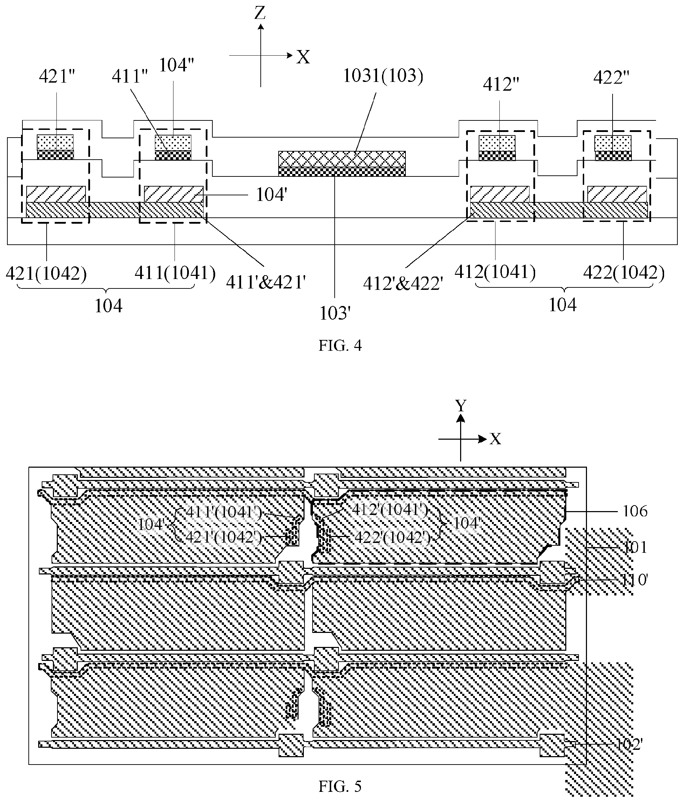

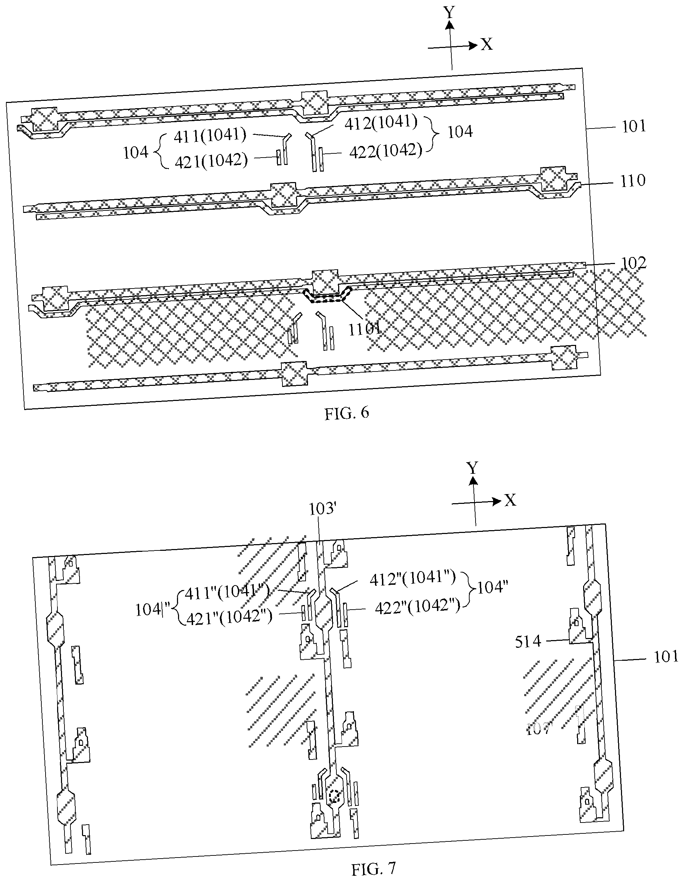

In some embodiments, the pattern of the layer where the common electrodes 106 are located and the layer where the gate lines 102 are located can be manufactured by one mask template. In the process, the pattern of the layer where the common electrodes 106 are located is first prepared using a mask, as shown in FIG.5. Next, the pattern of the layer where the gate lines 102 are located is prepared. Then, the gate insulation layer, such as the silicon nitride layer, is prepared. Optionally, in the present disclosure, the layer where the common electrodes 106 are located and the layer where the gate lines 102 are located are prepared with the same mask, which can reduce cost. Therefore, after the layer where the common electrodes 106 are located is prepared and patterned, a pattern of the common electrodes corresponding to the sub-pixel regions is formed and a pattern layer of the common electrodes corresponding to the region where the gate lines 10 are located is formed. Among them, the pattern layer of the common electrodes corresponding to the region where the gate lines 102 are located is in direct contact with the gate lines 102, realizing an electrical connection between them. In other words, at the positions corresponding to the gate lines 102, the layer where the common electrodes 106 are located overlaps with the gate lines 102 in the direction perpendicular to the base substrate 101. In this case, as shown in FIGS. 5 and 6, in the layer where the common electrodes 106 are located, there are patterns similar to those of the gate lines 102, the common electrode lines 110, and the barrier wall 104 (including the first barrier wall 1041, the second barrier wall 1042, the first barrier sub-wall 411, the second barrier sub-wall 412, the third barrier sub-wall 421, and the fourth barrier sub-wall 422) in the layer where the gate lines 102 are located; corresponding markings of which are 102', 110', 104', 1041', 1042', 411', 412', 421', 422'. Since the common electrodes 106 are block electrodes, the patterns 110', 104', 1041', 1042', 411', 412', 421', 422' of the common electrode corresponding to the common electrode line 110, the barrier wall 104 (including a first barrier wall 1041, a second barrier wall 1042, a first barrier sub-wall 411, a second barrier sub-wall 412, a third barrier sub-wall 421, and a fourth barrier sub-wall 422) in the region where the common electrodes 106 are located is integrated with each other, not independent of each other.

In some embodiments, in the above array substrate provided by the embodiment of the present disclosure, as shown in FIGS. 2, 3, 6 and 8, the gate electrode 511 of the transistor 105 can be a rectangular structure and be integrated with the gate line 102, the first electrode 512 of transistor 105 is a W-shaped structure, and the second electrode 513 of transistor 105 is a U-shaped structure. The orthographic projection of the W-shaped structure on the base substrate 101 is located in the orthographic projection of the rectangular structure on the base substrate 101, and the parallel edges of the U-shaped structure are respectively within two openings of the W-shaped structure. The transistor 105 with this structure is conducive to improving the pixel charging rate, and is especially suitable for products with the small resolution (PPI), large sub-pixel size, large areas of pixel electrode 109 and common electrode 106, and large storage capacitance Cst (such as 2.3 pF) between the pixel electrode 109 and the common electrode 106. The width length ratio of the channel of transistor 105 can be 83/3.8, which is much larger than the width length ratio 40/4 of the channel of the single transistor in the prior art, to adapt to the large storage capacitor Cst. In some embodiments, as shown in FIG. 3, the second electrode 513 has a hole h that at partially overlaps most with the gate electrode 511, which can ensure the parallel edges connectivity in the U-shaped structure of the second electrode 513 while considering alignment deviation (OVL) as much as possible to minimize the overlap between the second electrode 513 and the gate line 102, thereby reducing the parasitic capacitance Cgs between the gate line 102 and the second electrode 513. In some embodiments, in order to avoid short circuiting between the common electrode line 110 and the gate electrode 511 of the transistor 105, the common electrode line 110 can be set to include an avoidance portion 1101 that is recessed towards the side away from the transistor 105, as shown in FIG. 3.

In some embodiments, the transistor 105 can be a P-type transistor or an N-type transistor, and the transistor 105 can be a bottom gate transistor, a top gate transistor, or a double gate transistor, etc., which is not defined here. The first electrode 512 of the transistor 105 can be the source electrode and the second electrode 513 of the transistor 105 can be the drain electrode, or the first electrode 512 of the transistor 105 can be the drain electrode and the second electrode 513 of the transistor 105 can be the source electrode. The active layer 514 of the transistor 105 can be made of amorphous silicon (a-Si), polycrystalline silicon (poly), oxide (such as indium gallium zinc oxide IGZO), etc.

In some embodiments, the patterns of the layer where data lines 103 are located and the active layer 514 of the transistors 105 can be made using one mask template. Specifically, the semiconductor layer can be coated first, and then the data line layer can be coated. Next, one mask template can be used to pattern the data line layer to form the data lines 103, the first electrodes 512 and the second electrodes 513 of the transistors 105, the barrier walls 104 (including the first barrier walls 1041, the second barrier walls 1042, the first barrier sub-walls 411, the second barrier sub-walls 412, the third barrier sub-walls 421, and the fourth barrier sub-walls 422), and the adapter lines 107. Then, the semiconductor layer is patterned to form the active layer 154. Next, a passive layer PVX, such as silicon nitride layer, is coated, and the pixel electrode layer is coated and patterned to form the pixel electrode layer 109. In this case, as shown in FIGS. 7 and 8, the active layer 154 has patterns, which can be correspondingly marked as 103", 104", 1041", 1042", 411", 412", 421", 422", 107", similar to the data lines 103, the barrier walls 104 (including the first barrier walls 1041, the second barrier walls 1042, the first barrier sub-walls 411, the second barrier sub-walls 412, the third barrier sub-walls 421, the fourth barrier sub-walls 422), and the adapter lines 107 in the layer where the data lines 103 are located.

In some embodiments, in the array substrate provided by the embodiment of the present disclosure, as shown in FIG. 1, FIG. 11 to FIG. 14, the base substrate 101 can also include at least one fan-out region FA located on a side of the display region AA. The array substrate can also include a plurality of fan-out lines 111 located in the fan-out region FA. The fan-out lines 111 are oblique lines in the regionFA1, which are generally led from the chip on film COF to the position of the data lines 103 with which the fan-out lines need to be connected. The fan-out lines 111 are straight lines on the left and right sides of the region FA2, and the fan-out lines 111 below the region FA2 are serpentine lines, which are connected with the data lines 103. In order to ensure that the resistances of the fan-out lines 111 each are the same, the closer the fan-out line 111 to the symmetry axis MN of the chip film COF in the column direction Y, the shorter the fan-out line 111 is wound. Different winding lengths result in a blank in the region FA2 (i.e., gap S). The inventor found that when the difference of metal densities in the wiring region is below 53%, the difference of etching amount caused by the difference of etching uniformity is small. The smaller the line width, the higher the possibility of cutting off by etching. Generally, when the line width is larger than or equal to 4.5 µm, the yields have a little difference. However, in the present disclosure, the metal densities of regions FA1 and FA2 are 68.13% and 1.4% respectively, with a difference of about 66.7% more than 53%, and the metal line width in the region FA2 is 3.9 µm. The risk of line breakage will be high. In the present disclosure, the first dummy line(s) 112 can be set at the gap S, and the first dummy line 112 is routed along the boundary of the gap S within the gap S of the fan-out lines 111, so that the fan-out lines 111 around the gap S can be protected by the first dummy lines 112 in the same direction, ensuring the uniformity of etching, and reducing the risk of line breakage.

The inventor found that laying 4 or 5 first dummy lines 112 in the gap S can effectively prevent the fan-out lines 111 from breaking. Therefore, the first dummy lines 112 in the present disclosure can be set 4 or 5. In this case, if the gap S is large, there will still be a blank region on the inside of all the first dummy lines 112 away from the fan-out lines 111. Of course, in some embodiments, more than 5 first dummy lines 112 can be set, and the first dummy lines 112 can be evenly arranged at the gap S.

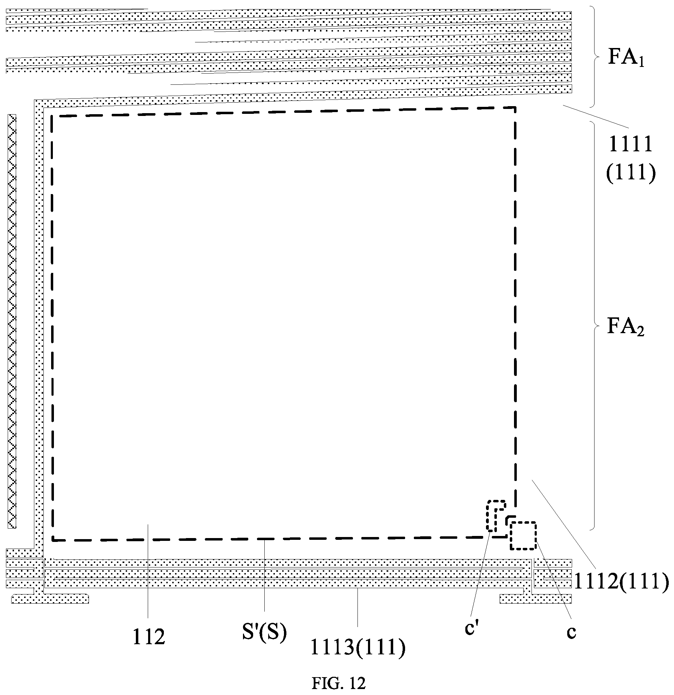

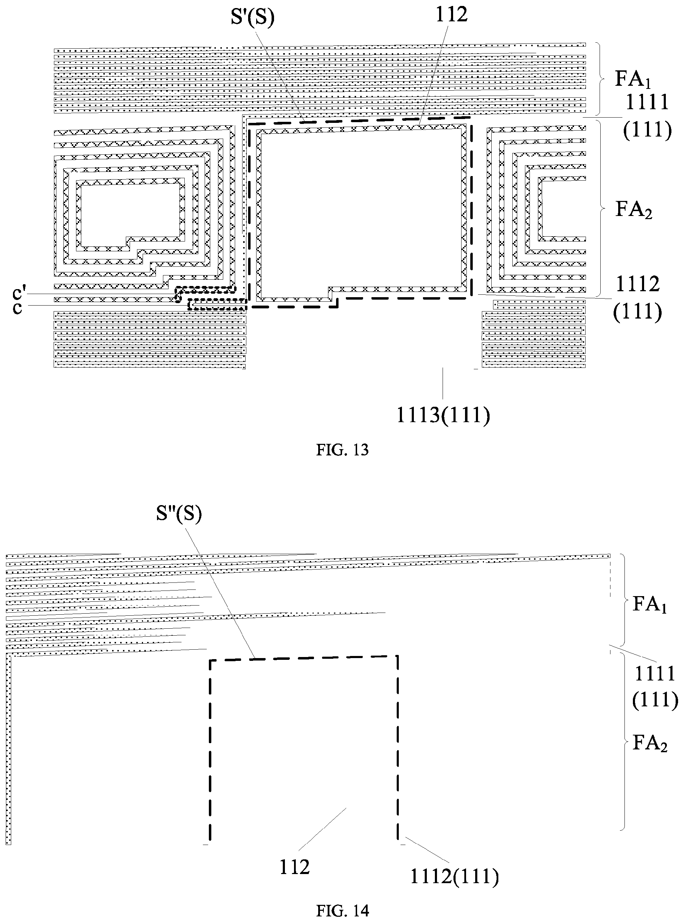

In some embodiments, in the above array substrate provided by embodiments of the present disclosure, as shown in FIGS. 11 to 13, at least some of the fan-out lines 111 include the serpentine lines 1111, the straight lines 1112 and the oblique lines 1113 connected in turn in the direction away from the display region AA. In the present disclosure, the straight line 1112 has the same extending direction as the data line 103, and the oblique line 1113 has an included angle with respect to the extending direction of the gate line 102. The gap S enclosed by at least some of the straight line 1112, the serpentine line 1111 and the oblique line 1113 is the closed space S', and the closed space S' is provided with a plurality of closed first dummy lines 112 that are routed along the boundary of the closed space S'. In some embodiments, as shown in FIGS. 12 and 13, the closed space S' includes a first convex portion c extending towards the center of the closed space S', accordingly, at least some of the first dummy line 112 can include a second convex portion c' around the first convex portion c. For example, in the second closed space S' from the left of FIG. 13, a first dummy line 112 close to the boundary of the closed space S' includes the second convex portion c', and a first dummy line 112 located in the central region of the closed space S' can be a rectangular dummy line without the second convex portion c'. In the first closed space S' from the left of FIG. 12 and FIG. 13, all the first dummy lines 112 include second convex portions c'. In some embodiments, as shown in FIG. 11, the first and fourth closed spaces S' from the left are rectangular, and accordingly, the first dummy lines 112 inside them are rectangular. Optionally, in the present disclosure, the density of the dummy lines is less than the density of the fan-out lines.

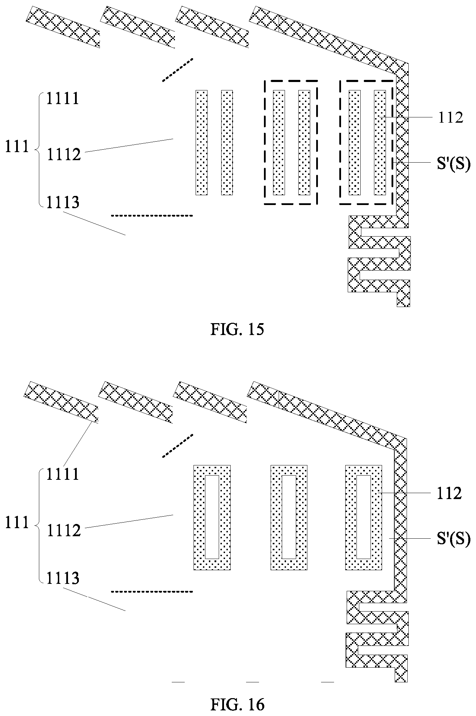

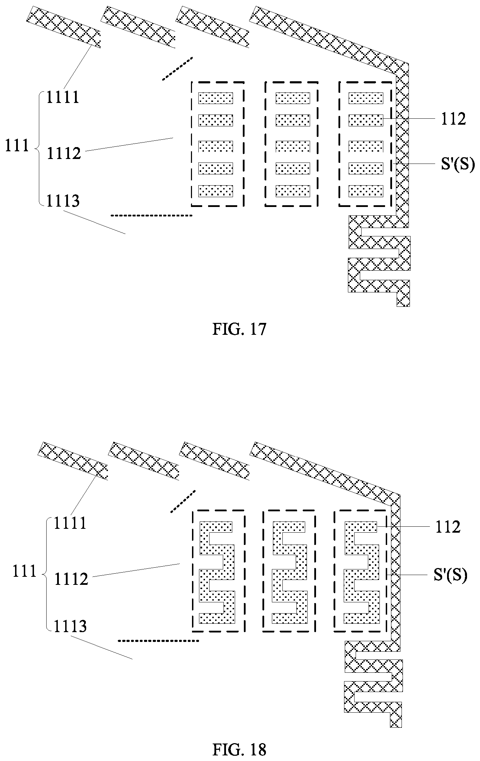

It should be understood that, as shown in FIGS. 15 to 18, the first dummy line 112 in the closed space S' in the present disclosure can also be in at least one form of, such as a rectangular shape, a serpentine shape, parallel to the straight line 1112, and substantially perpendicular to the straight line 1112. However, the first dummy lines 112 in these forms can only protect the fan-out lines 111 close to them. Therefore, in the present disclosure, it is preferred to set the first dummy line 112 in the closed space S' by wiring the entire circle as shown in FIGS. 12 and 13.

In some embodiments, in the above array substrate provided by the embodiment of the present disclosure, as shown in FIGS. 11 and 14, the gap S can be a semi-closed space S", for example, at least some of the straight lines 1112 and the oblique lines 1113 are enclosed in a semi-closed space S" with an opening on the side facing the display region AA and approximate to a square wave shape. The semi-closed space S" is located at the side of the closed space S' away from the symmetric axis MN extending along the column direction Y of the fan-out region FA, and there are at least a plurality of semi-closed first dummy lines 112 in the semi-closed space S" that are routed along the boundary of the semi-closed space S". For example, in FIG. 14, all the first dummy lines 112 in the semi-closed space S" are semi-closed dummy lines that are routed along the boundary of the semi-closed space S". In the third semi-closed space S" from the left in FIG. 11, the first dummy line 112 set close to the boundary of the semi-closed space S" is a semi-closed dummy line, and the first dummy line 112 located in the central region of semi-closed space S" is a closed dummy line.

In some embodiments, in the above array substrate provided by the embodiment of the present disclosure, as shown in FIG. 1, FIG. 19 and FIG. 20, there are at least two the fan-out regions FA, and the array substrate also includes the first common electrode bus 113 between two fan-out regions FA that are adjacent to each other, and a plurality of second dummy lines 114 between the fan-out regions FA and the first common electrode bus 113. The first common electrode bus 113 includes a plurality of common electrode sub-lines 1131 connected in parallel. The common electrode sub-lines 1131 are substantially parallel (that is, parallel or within the error range caused by factors such as manufacturing and measurement) to the fan-out lines 111 at the edges, that are adjacent to the common electrode sub-lines, of two fan-out regions AA, and a plurality of second dummy lines 114 are connected in parallel or independently of each other. The second dummy line 114 is substantially parallel (that is, parallel or within the error range caused by manufacturing, measuring and other factors) to the fan-out line 111 at the edge of a single fan-out region FA that is adjacent to the second dummy lines. In this way, while adding the second dummy line(s) 114 with the same shape as the fan-out line 111 at the edge, the shape of the common electrode sub-line 1131 outside the edge of the fan-out region FA is also designed to be similar to the shape of the fan-out line 111, which is more conducive to increasing the etching uniformity of the fan-out lines 111 at the edge of the fan-out region FA. Considering that the second dummy line 114 is closer to the fan-out line 111 than the first common electrode bus 113, the first dummy line 114 has a greater impact on the etching uniformity of the fan-out lines 111. Based on this, in the present disclosure, the distance between the first common electrode bus 113 and the second dummy line 114 can be greater than the distance between the second dummy line 114 and the fan-out line 111.

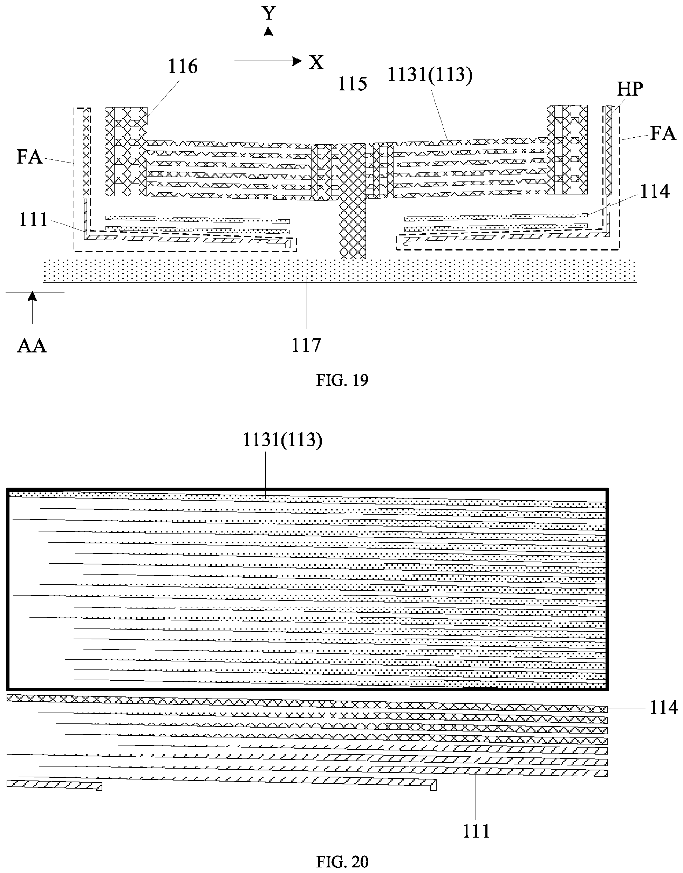

Further referring to FIG. 19, it can be seen that the first parallel line 115 and the second parallel line 116 can be set between the two fan-out regions FA that are adjacent to each other, and the second common electrode bus 117 extending along the extending direction of the gate line 102 can be set in the non-display region. The first parallel line 115 is coupled between the middle portions of the plurality of common electrode sub-lines 1131 and the second common electrode bus 117. The second parallel line 116 is coupled with the end portions of the plurality of common electrode sub-lines 1131. In this way, the parallel connection of the plurality of common electrode sub-lines 1131 can be achieved using the first parallel line(s) 115 and the second parallel line(s) 116. At the same time, one end of the second parallel line 116 that is not coupled with the common electrode sub-line 1131 can be coupled with the circuit board (optionally, which is the flexible circuit board or printed circuit board), so that the common voltage signal provided by the circuit board and the like is transmitted to the second common electrode bus 117 extending along the extending direction of the gate line 102 and in the non-display region through the second parallel line 116, the common electrode sub-line 1131 and the first parallel line 115 in turn. Optionally, the circuit board is equipped with a source driver chip (source IC). Continuing to refer to FIG. 19, the display region AA is set on the side of the second common electrode bus 117 away from the first parallel line 115, and the common electrode(s) included in the display region AA can be electrically connected with the second common electrode bus 117. Specifically, the electrical connection can be realized through the via hole, for example, the second common electrode bus 117 is in the same layer as the gate lines 102, and the common electrode(s) can realize the electrical connection between the electrode layer and the gate line layer through the via hole. Optionally, a plurality of signal lines (4 lines are set in FIG. 19, the specific number is unlimited, and the same number of signal lines can be set on both sides of the first parallel line 115) with the same extending direction as the data lines 103 are set on both sides of the first parallel line(s) 115 to connect the plurality of common electrode sub-lines 1131 together. Optionally, the second common electrode bus 117, the first parallel line 115, and the signal lines on both sides of the first parallel line 115 are arranged in the same layer, for example, can be located in the gate line layer, and are made of the same material,. Continuing to refer to FIG. 19, the non-display region also includes the pad HP structure. The pad HP is used for electrical connection with the data line 103. When the circuit board (such as the flexible circuit board) is bound with the pad HP, the pad HP is used to transmit the data signal to the data line 103. In the present disclosure, the second parallel line 116 can be electrically connect the plurality of common electrode sub-lines 1131 to the circuit board and transmit the common electrode signal. The number of fan-out line 111 and the number of the second dummy line 114 shown in FIG. 19 can be multiple. One end of the fan-out line 111 is electrically connected to the pad HP, and the other end of the fan-out line 111 is electrically connected to the data line 103 in the display region AA.

In some embodiments, in the array substrate provided by the embodiment of the present disclosure, the line width of the first dummy line 112, the line width of the second dummy line 114, the line width of the common electrode sub-line 1131 and the line width of the fan-out line 111 can be substantially the same (that is, the same, or within the error range caused by manufacturing, measurement and other factors). A line space between the first dummy lines 112, a line space between the second dummy lines 114, and a line space between the common electrode sub-lines 1131 are 1 to 10 times a line space between the fan-out lines 111. For example, the line space between two adjacent fan-out lines 111 is in a range of 3.5 µm to5.5 µm. The line space between the first dummy lines 112, the line space between the second dummy lines 114, and the line space between the common electrode sub-lines 1131 are all in a range of 3.5 µm to30 µm, e.g., 3.5 µm, 5 µm, 10 µm, 15 µm, 20 µm, 25 µm, or 30 µm, etc. Within this range, it can not only prevent line breakage, but also avoid short circuit caused by excessive electrostatic accumulation in the process. Optionally, to ensure the best etching uniformity, the line space between the first dummy lines 112, the line space between the second dummy lines 114, and the line space between the common electrode sub-lines 1131 can be the same as the line space between the fan-out lines 111.

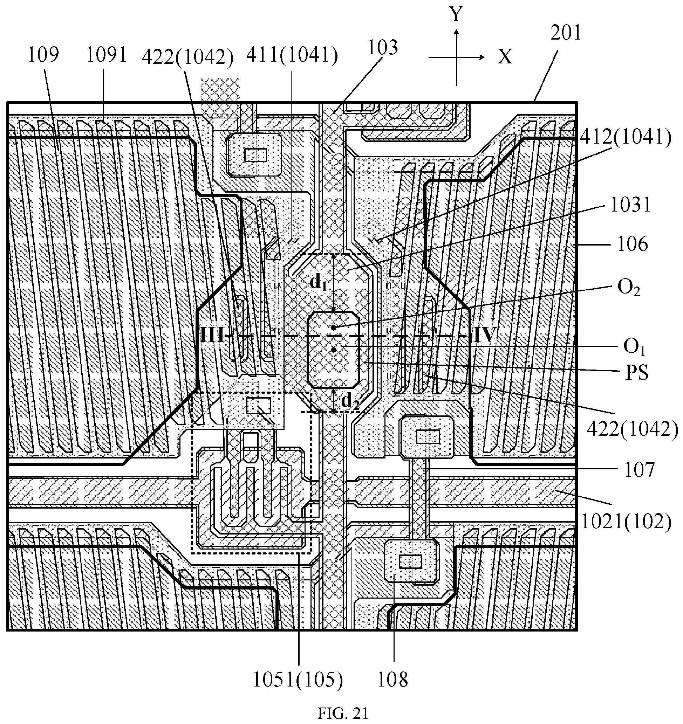

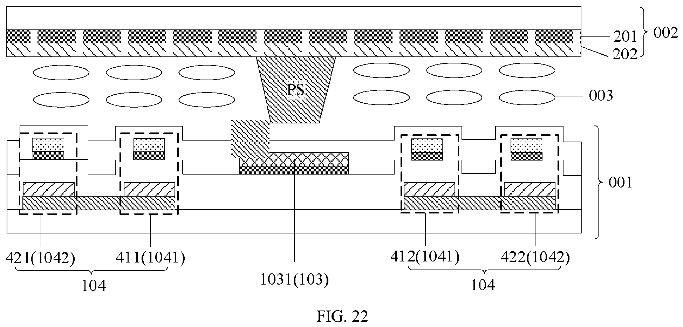

Based on the same inventive concept, embodiments of the present disclosure provide a display apparatus, as shown in FIGS. 21 and 22, including an array substrate 001 and an opposing substrate 002 disposed opposite to each other, and a liquid crystal layer 003 disposed between the array substrate 001 and the opposing substrate 002, where the array substrate 001 is the above-described array substrate provided in embodiments of the present disclosure. The opposing substrate 002 includes a black matrix 201 and a color resist 202, etc. Due to the similarity between the principle of the display device solving the problem and the principle of the array substrate solving the problem mentioned above, the implementation of the display device can refer to the implementation example of the array substrate mentioned above, and the repetition will not be repeated.

In some embodiments, in the above display apparatus provided by the embodiment of the present disclosure, as shown in FIGS. 21 and 22, the orthographic projection of the barrier wall 104 on the base substrate 101 is within the orthographic projection of the black matrix 201 on the base substrate 101 to prevent the metal reflection caused by the leaking out of the barrier wall 104. Continuing to refer to FIG. 21, it can be seen that, the orthographic projection of the black matrix 201 on the base substrate 101 can exceed 3 µm to 7 µm than the orthographic projection of the common electrode line 110 on the base substrate 101 to improve the aperture ratio. In addition, at least some of the slits 1091 include a first end close to the common electrode line 110 and a second end away from the common electrode line 110. Optionally, to avoid liquid crystal distortion and light leakage caused by the presence of common electrode line 110 at the first end, the orthographic projection of the first end on the base substrate 101 can overlap with the orthographic projection of the black matrix 201 on the base substrate 101, and the orthographic projection of the second end on the base substrate 101 does not overlap with the orthographic projection of the black matrix 201 on the base substrate 101.

In some embodiments, the above-mentioned display apparatus provided in the disclosed embodiments may also include a backlight module on the light incident side of the array substrate 001. The backlight module can be a direct-lit backlight module or an edge-lit backlight module. Optionally, the edge-lit backlight module may include the light bars, the reflective sheet, the light guide plate, the diffusion sheet, the prism group, that are stacked, etc. The light bars are located on one side in the thickness direction of the light guide plate. The direct-lit backlight module may include a matrix light source, and a reflective sheet, a diffusion plate, a brightness enhancement film, etc. that are stacked on the light emergent side of the matrix light source. The reflective sheet includes holes that are positioned opposite to the positions of lamp beads in the matrix light source. The lamp beads in the light bars and the lamp beads in the matrix light source can be light-emitting diodes (LEDs), such as micro-light-emitting diodes (e.g., Mini LED, Micro LED, etc.).

Miniature light-emitting diodes at the sub-millimeter or even micron scales are self-luminous devices like organic light-emitting diodes (OLEDs). Like organic light-emitting diodes, they have a series of advantages such as high brightness, ultra-low latency, and ultra-large viewing angle. Moreover, due to the fact that inorganic light-emitting diodes emit light based on metal semiconductors with more stable properties and lower resistances, they have the advantages of lower power consumption, better resistance to high and low temperatures, and longer service life compared to organic light-emitting diodes that emit light based on organic compounds. When micro light-emitting diodes are used as backlight sources, more precise dynamic backlighting effects can be achieved, effectively improving screen brightness and contrast while also solving the glare phenomenon caused by traditional dynamic backlighting between bright and dark regions of the screen, optimizing the visual experience.

In some embodiments, the display apparatus according to embodiments of the present disclosure may be any product or component having a display function, such as a projector, a three dimensional (3D) printer, a virtual reality device, a mobile phone, a tablet computer, a television, a display, a notebook computer, a digital photo frame, a navigator, a smart watch, a fitness wristband, and a personal digital assistant. Optionally, the display apparatus provided in the present disclosure includes but is not limited to, a radio frequency unit, a network module, an audio output-input unit, a sensor, a display unit, a user input unit, an interface unit, a control chip, and other components. In some embodiments, the control chip is a central processing unit, a digital signal processor, a system-on-a-chip (SoC), etc. For example, the control chip may further include a memory, a power module, etc., and power supply and signal input and output functions are achieved through additionally arranged wires and signal lines. For example, the control chip may further include a hardware circuit and a computer executable code. The hardware circuit may include a conventional very large scale integration (VLSI) circuit or a gate array and existing semiconductors such as a logic chip and a transistor or other discrete elements. The hardware circuit may further include a field programmable gate array, a programmable array logic, a programmable logic device, etc. In addition, those skilled in the art can understand that the above structure does not limit the display apparatus according to the embodiment of the present disclosure. That is, the display apparatus according to the embodiment of the present disclosure may include more or less components, or combine some components, or have different component arrangements.

Although the present disclosure has described preferred embodiments, it should be understood that those skilled in the art can make various changes and modifications to the disclosed embodiments without departing from the spirit and scope of the disclosed embodiments. Thus the present disclosure is also intended to encompass these modifications and variations therein as long as these modifications and variations to the present disclosure come into the scope of the claims of the present disclosure and their equivalents.

## Claims

1. An array substrate, comprising:
a base substrate, wherein the base substrate comprises a display region, the display region comprises a plurality of sub-pixel region arranged in an array, colors of the sub-pixel regions in the same row are the same, at least two sub-pixel regions that are adjacent to each other and in the same column are one pixel region, and colors of the sub-pixel regions in the same one pixel region are different;
a plurality of gate lines and a plurality of pixel circuits, located at row gaps of the sub-pixel regions, wherein one gate line is coupled with one row of the sub-pixel regions through the pixel circuits;
a plurality of data lines, located at column gaps of the sub-pixel regions, wherein one data line is coupled with two columns of the sub-pixel regions through the pixel circuits, the sub-pixel regions coupled with the same one data line and located in rows that are adjacent to each other are respectively located in columns that are adjacent to each other, at least some of the data lines comprises abutments for supporting spacers, and the at least some of the data lines are widened at the abutments; and
at least one barrier wall that is close to the abutment, wherein in a direction pointing perpendicularly from the base substrate to a layer where the data lines are located, a surface of the barrier wall facing away from the base substrate is higher than a surface of the data line facing away from the base substrate, and the barrier wall at least partially surrounds the abutment.

2. The array substrate according to claim 1, wherein the abutments are located between at least some of the sub-pixel regions that are adjacent to each other in the same row, the gate lines comprises a first gate line, and the first gate line is coupled with the sub-pixel regions in a row in which the abutments are located; and
the barrier wall comprises a first barrier wall, and the first barrier wall is bent from a side of the abutment extending in a column direction to a side of the abutment away from the first gate line.

3. The array substrate according to claim 2, wherein the pixel circuits comprise transistors, the transistors are coupled with the data lines, the gate lines, and the sub-pixel regions, respectively; the transistors comprise a first transistor, the first transistor is coupled with the data line in which the abutment is located, and the first transistor is adjacent to the abutment on a side of the abutment extending in the column direction; and
the first barrier wall comprises a first barrier sub-wall and a second barrier sub-wall; the first barrier sub-wall and the first transistor are located on the same side of the abutment; and the first barrier sub-wall is located on a side of the first transistor away from the first gate line; the second barrier sub-wall and the first transistor are separated on both sides of the abutment, an end portion of the second barrier sub-wall away from the first gate line is substantially flush with an end portion of the first barrier sub-wall away from the first gate line in a row direction; and an end portion of the second barrier sub-wall close to the first gate line is closer to the first gate line than an end portion of the first barrier sub-wall close to the first gate line.

4. The array substrate according to claim 2 or 3, wherein the barrier wall further comprises a second barrier wall, and the second barrier wall extends in the column direction on a side of the first barrier wall away from the abutment;
on the same side of the abutment extending in the column direction, and an end portion of the second barrier wall close to the first gate line is substantially flush with an end portion of the first barrier wall close to the first gate line in the row direction; and
an end portion of the second barrier wall away from the first gate line is closer to the first gate line than an end portion of the first barrier wall away from the first gate line.

5. The array substrate according to claim 4, wherein the pixel circuits comprise transistors, the transistors are coupled with the data lines, the gate lines, and the sub-pixel regions, respectively; the transistors comprise a first transistor, the first transistor is coupled with the data line in which the abutment is located, and the first transistor is adjacent to the abutment on a side of the abutment extending in the column direction; and
the second barrier wall comprises a third barrier sub-wall and a fourth barrier sub-wall; the third barrier sub-wall and the first transistor are located on the same side of the abutment, and the third barrier sub-wall is located on a side of the first transistor away from the first gate line; the fourth barrier sub-wall and the first transistor are separated on both sides of the abutment, an end portion of the fourth barrier sub-wall away from the first gate line is substantially flush with an end portion of the third barrier sub-wall away from the first gate line in a row direction, and an end portion of the fourth barrier sub-wall close to the first gate line is closer to the first gate line than an end portion of the third barrier sub-wall close to the first gate line.

6. The array substrate according to claim 3 or 5, further comprising a plurality of common electrodes and a plurality of adapter lines; wherein the common electrodes are located in the sub-pixel regions, the common electrodes located in the same row are integrally arranged; the common electrodes that are adjacent to each other in the same column are connected through the adapter line; the adapter lines are arranged in the same layer as the data lines, and some of the adapter lines are close to the abutment on a side of the abutment away from the first transistor.

7. The array substrate according to any one of claims 2 to 6, wherein the abutment comprises a spacer station region, a center of the spacer station region is closer to the first gate line than a center of the abutment.

8. The array substrate according to any one of claims 1 to 7, wherein the barrier wall comprises a first barrier wall portion and a second barrier wall portion that are stacked; the first barrier wall portion is in the same layer as the gate lines, and the second barrier wall portion is in the same layer as the data lines.

9. The array substrate according to any one of claims 1 to 8, further comprising: a plurality of pixel electrodes located in the sub-pixel regions; wherein the pixel electrode comprises a plurality of slits, and orthographic projections of the plurality of slits on the base substrate and an orthographic projection of the barrier wall on the base substrate overlap with each other.

10. The array substrate according to claim 9, wherein the orthographic projections of the plurality of slits on the base substrate and orthographic projections of the gate lines on the base substrate do not overlap with each other.

11. The array substrate according to claim 9 or 10, further comprising: a plurality of common electrodes and a plurality of common electrode lines; the common electrodes are located in the sub-pixel regions, one common electrode line is coupled with one row of common electrodes; and the orthographic projections of the plurality of slits on the base substrate and orthographic projections of the common electrode lines on the base substrate overlap with each other.

12. The array substrate according to any one of claims 9 to **11,** wherein a length of the pixel electrode in the row direction is greater than a length of the pixel electrode in the column direction.

13. The array substrate according to any one of claims 1 to 12, further comprising: a plurality of common electrodes and a plurality of common electrode lines; wherein the pixel circuits comprise transistors, the transistors are coupled with the data lines, the gate lines, and the sub-pixel regions, respectively; the common electrodes are located in the sub-pixel regions; one common electrode line is coupled with one row of common electrodes; and the common electrode line comprises avoidance portions, the avoidance portions are recessed towards a side away from the transistors.

14. The array substrate according to any one of claims 1 to 13, wherein the pixel circuits comprise transistors, the transistors are coupled with the data lines, the gate lines, and the sub-pixel regions, respectively; the transistor comprises a gate electrode, a first electrode of the transistor is a W-shaped structure, and a second electrode of the transistor is a U-shaped structure; an orthographic projection of the W-shaped structure on the base substrate is within an orthographic projection of the gate electrode on the base substrate; and parallel edges of the U-shaped structure are respectively within two openings of the W-shaped structure.

15. The array substrate according to any one of claims 1 to 14, wherein the base substrate further comprises at least one fan-out region located on a side of the display region; and
the array substrate further comprises: a plurality of fan-out lines and a plurality of first dummy lines in the fan-out region, the fan-out lines are coupled with the data lines; the first dummy lines are between at least some of the fan-out lines; and the first dummy lines are routed within gaps between the fan-out lines, and along the boundaries of the gaps.

16. The array substrate according to claim 15, wherein the gap is a closed space surrounded by the fan-out lines, the closed space have a plurality of closed first dummy lines routed along a boundary of the closed space.

17. The array substrate according to claim 16, wherein the closed space comprises a first convex portion extending towards a center of the closed space, and at least the first dummy line close to the boundary of the closed space comprises a second convex portion around the first convex portion.

18. The array substrate according to claim 17, wherein all of the first dummy lines within the closed space comprise the second convex portions.

19. The array substrate according to claim 17, wherein the first dummy line close to the boundary of the closed space comprises the second convex portion, and the first dummy line located in a center region of the closed space is a rectangular dummy line.

20. The array substrate according to claim 16, wherein the closed space is rectangular and the first dummy line is a rectangular dummy line.

21. The array substrate according to claim 15, wherein the gap is a semi-closed space that opens on a side towards the display region; the semi-closed space is located on a side of the closed space away from a symmetry axis extending in the column direction of the fan-out region; and the semi-closed space at least have a plurality of semi-closed first dummy lines routed along a boundary of the semi-closed space.

22. The array substrate according to claim 21, wherein all of the first dummy lines within the semi-closed space are semi-enclosed dummy lines routed along the boundary of the semi-closed space.

23. The array substrate according to claim 22, wherein the first dummy line close to the boundary of the semi-closed space is the semi-enclosed dummy line, and the first dummy line located in a center region of the semi-closed space is a closed dummy line.

24. The array substrate according to claim 15, wherein at least some of the fan-out lines comprises: serpentine lines, straight lines, and oblique lines sequentially connected in a direction away from the display region; at least some of the straight lines, the serpentine lines, and the oblique lines enclose a closed space; and the closed space comprises at least one of: a rectangular first dummy line, a serpentine first dummy line, a first dummy line parallel to the straight line, or a first dummy line substantially perpendicular to the straight line.

25. The array substrate according to any one of claims 15 to 24, comprising at least two fan-out regions, and a first common electrode bus between two fan-out regions that are adjacent to each other; and a plurality of second dummy lines between the fan-out regions and the first common electrode bus; wherein the first common electrode bus comprises a plurality of common electrode sub-lines connected in parallel, the common electrode sub-lines are substantially parallel to the fan-out lines at edges, that are adjacent to the common electrode sub-lines, of the two fan-out regions; the plurality of second dummy lines are connected in parallel or are arranged independently of each other, and the second dummy lines are substantially parallel to the fan-out line at an edge of a single fan-out region that is adjacent to the second dummy lines.

26. The array substrate according to claim 25, further comprising: a first parallel line and a second parallel line between the two fan-out regions that are adjacent to each other, and a second common electrode bus in the non-display region and extending in an extending direction of the gate line; wherein the first parallel line is coupled between middle portions of the plurality of common electrode sub-lines and the second common electrode bus, and the second parallel line is coupled with end portions of the plurality of common electrode sub-lines.

27. The array substrate according to claim 25 or 26, wherein a distance between the first common electrode bus and the second dummy line is greater than a distance between the second dummy line and the fan-out line.

28. The array substrate according to any one of claims 25 to 27, wherein a line width of the first dummy line, a line width of the second dummy line, and a line width of the common electrode sub-line are substantially the same as a line width of the fan-out line, and a line space between the first dummy lines, a line space between the second dummy lines, and a line space between the common electrode sub-lines are 1 to 10 times a line space between the fan-out lines.

29. A display apparatus, comprising: an array substrate and an opposing substrate opposite to each other, and a liquid crystal layer between the array substrate and the opposing substrate, wherein the array substrate is the array substrate according to any one of claims 1 to 28.

30. A display apparatus according to claim 29, wherein the opposing substrate comprises a black matrix; and an orthographic projection of the barrier wall on the base substrate is within an orthographic projection of the black matrix on the base substrate.

31. The display apparatus according to claim 30, wherein the array substrate comprises a common electrode line; in the sub-pixel region, the orthographic projection of the black matrix on the base substrate exceeds 3 µm to 7 µm than an orthographic projection of the common electrode line on the substrate.

32. The display apparatus according to claim 31, wherein the array substrate comprises pixel electrodes, and each the pixel electrode comprises slits; at least some of the slits comprise: a first end close to the common electrode line, and a second end away from the common electrode line; wherein an orthographic projection of the first end on the base substrate and the orthographic projection of the black matrix on the base substrate overlap with each other, and an orthographic projection of the second end on the base substrate and the orthographic projection of the black matrix on the base substrate do not overlap with each other.

33. The display apparatus according to any one of claims 29 to 32, wherein the data line comprises the abutment, and the abutment comprises a spacer station region; the opposing substrate comprises a spacer; a size of the spacer gradually decreases in a direction pointing from the opposing substrate to the liquid crystal layer; and an orthographic projection of an end portion of the spacer close to the array substrate on the base substrate substantially coincides with an orthographic projection of the spacer station region on the base substrate.
